(19) Europäisches Patentamt
European Patent Office
Office européen des brevets

(11) **EP 2 819 177 B1**

(12) **EUROPEAN PATENT SPECIFICATION**

(45) Date of publication and mention
of the grant of the patent:
**20.12.2017 Bulletin 2017/51**

(51) Int Cl.:
***H01L 31/042*** *(2014.01)* ***B32B 27/36*** *(2006.01)*
***H01L 31/18*** *(2006.01)*

(21) Application number: **13752220.7**

(22) Date of filing: **20.02.2013**

(86) International application number:
**PCT/KR2013/001319**

(87) International publication number:
**WO 2013/125837 (29.08.2013 Gazette 2013/35)**

(54) **BACK SHEET FOR SOLAR MODULE AND METHOD FOR MANUFACTURING SAME**

RÜCKSEITIGE FOLIE FÜR SOLARMODUL UND VERFAHREN ZUR HERSTELLUNG DAVON

FEUILLE ARRIÈRE DESTINÉE À UN PANNEAU SOLAIRE PHOTOVOLTAÏQUE ET SON PROCÉDÉ DE FABRICATION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **23.02.2012 KR 20120018665**

(43) Date of publication of application:
**31.12.2014 Bulletin 2015/01**

(73) Proprietor: **Kolon Industries, Inc.
Gwacheon-si, Gyeonggi-do 13837 (KR)**

(72) Inventors:
• **KIM, Tae Hyeon
Hongseong-gun
Chungcheongnam-do 350-818 (KR)**
• **BAEK, Sang-Hyun
Gumi-si
Gyeongsangbuk-do 730-040 (KR)**
• **KIM, Si Min
Daegu 704-140 (KR)**

(74) Representative: **Ter Meer Steinmeister & Partner
Patentanwälte mbB
Nymphenburger Straße 4
80335 München (DE)**

(56) References cited:
WO-A1-2011/118844      JP-A- H05 220 895
JP-A- H06 328 629       JP-A- 2004 237 543
JP-A- 2009 114 362      JP-A- 2010 251 679
KR-A- 20120 009 438     KR-B1- 940 004 166

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

[FIELD OF THE INVENTION]

The following disclosure relates to a back sheet for a solar cell module and a manufacturing method thereof, and more particularly, to a back sheet for a solar cell module having a novel laminate structure capable of substituted for an existing structure in which poly vinyl fluoride (PVF, Tedlar) film/polyethylene terephthalate (PET) film/PVF (Tedlar) film are sequentially laminated, excellent hydrolysis resistance, and significantly excellent heat adhesion, and a manufacturing method thereof.

[BACKGROUND OF THE INVENTION]

A solar cell for solar power generation is made of silicon or various compounds and may generate electricity. However, since sufficient output may not be obtained from a single solar cell, each of the solar cells should be connected in series or in parallel with each other. A state in which the solar cells are connected to each other as describe above is called a 'solar cell module'.

The solar cell module is configured of glass, ethylene vinyl acetate (EVA), solar cells, EVA, and a back sheet that are sequentially laminated therein. As the back sheet, which is laminated at the lowermost position of the module to serve to block dust, impact, and moisture to protect the solar cell, a TPT (Tedlar/PET/Tedlar) type back sheet are mainly used. In addition, since a ribbon is used as a path through which current flows, as the ribbon, a material made of copper coated with silver or a tin-lead alloy is used.

The back sheet for a solar cell module is a core material attached to a back surface of the solar cell module to protect cell. Since the back sheet requires properties such as durability, water resistance, and water permeation resistance the back sheet is generally manufactured by laminating a fluoride film and a polyethylene terephthalate (PET) film.

The fluoride film having excellent water resistance and durability is used on both surfaces of the back sheet. Currently, a Tedlar film made of a poly vinyl fluoride resin developed by DuPont in 1961 has been mainly used, but the Tedlar film is expensive and is not sufficiently supplied, such that some companies use another film such as the PET film instead of the Tedlar film.

EVA was co-developed by NASA and DuPont as a material for a solar cell used in an artificial satellite in 1970. Currently, EVA is used as a standard sealing material for a solar cell. Japanese companies (Mitsui Chemical, Bridgestone) occupy more than 70% of the global market in the EVA field. EVA serves to seal and fill the cell in the solar cell. EVA has excellent strength, transparency, and insulating property.

As the polyethylene terephthalate (PET) film, a plate plastic film having a predetermined thickness and properties is used, and the PET film has excellent strength to form a basic frame of the back sheet. The PET film has excellent physical, chemical, mechanical, and optical properties to thereby be widely used from food packages and office supplies to high-tech electric and electronic products such as a semiconductor and a display. Recently, due to excellent durability and water resistance, the use of the PET film in the back sheet for a solar cell has been increased.

The glass in which a content of iron is low is used so as to serve to prevent reflection of light.

According to the related art, in the TPT (Tedlar/PET/Tedlar) type back sheet, in order to laminate the Tedlar film and the PET film, a process of laminating each film using an adhesive has been required, and in order to adhere the back sheet and the EVA film, which is a sealing film, to each other, a process of adhering the back sheet and the EVA film using an adhesive such as a polyurethane adhesive has been additionally required. Since the Tedlar film used in the existing back sheet is expensive, cost of the Tedlar film currently occupies more than 80% of a manufacturing cost of the back sheet, which is a reason for cost increase in the back sheet.

Therefore, in order to decrease the manufacturing cost, research into a technology of not using the Tedlar film attached to the sealing film (EVA film) has been attempted. For example, a technology of forming an ethylene vinyl acetate adhesive layer on a polyester film by an in-line coating method in order to substitute for the Tedlar film has been disclosed in Korean Patent Laid-Open Publication No. 10-2011-0118953 (November 2, 2011), a technology of forming a hot-melt adhesive layer on a polyester film by an in-line coating method in order to substitute for the Tedlar film has been disclosed in Korean Patent Laid-Open Publication No. 10-2011-0119134 (November 2, 2011), and a technology of decreasing a process and cost by applying a fluoride coating composition substituting for the existing Tedlar film layer onto a polyester film by an off-line coating method to form a fluoride coating layer has been disclosed in Korean Patent Laid-Open Publication No. 10-2011-0118271 (October 31, 2011).

The present invention relates to a technology of further improving adhesive force than those in Korean Patent Laid-Open Publication Nos. 10-2011-0118953 and 10-2011-0119134 to form a polyethylene adhesive layer on a polyester film by an in-line coating method. According to the related art, adhesive force to the sealing ethylene vinyl acetate is lower than that of the back sheet having the fluoride layer /polyester film/fluoride layer structure. However, according to the present invention, the adhesive force may be increased 2 to 3 times than that in the related art and be similar to adhesive force between the fluoride layer in the fluoride layer /polyester film/fluoride layer and the sealing ethylene vinyl acetate.

JP 2010 251679 A is directed to a solar cell module which has a filler layer formed by covering a solar cell element with a filler and a sealing layer for sealing it, and an adhesive being an aqueous dispersion containing an acid modified polyolefin resin containing a 0.1 to 10 mass% unsaturated carboxylic acid.

WO 2011/118844 A1 is directed to a solar cell backsheet comprising an adhesive layer include a binder and inorganic fine particles in an amount of 50% to 200% by volume of the total volume of the binder.

[DETAILED DESCRIPTION OF THE INVENTION]

[TECHNICAL PROBLEM]

The present inventors studied in order to solve process problems and a cost increase problem caused by an adhesive application process performed through various steps and discovered that the process and cost may be decreased by forming an adhesive layer on a polyester film by an in-line coating method, thereby completing the present invention.

An embodiment of the present invention is directed to providing an adhesive layer capable of having more excellent adhesion with EVA, which is a sealing material as compared to the related art, and exhibiting adhesive force equal to or more than that of the existing Tedlar film.

[TECHNICAL SOLUTION]

The present invention for achieving the above-mentioned object is as follows.

In one general aspect, there is provided a back sheet for a solar cell module including a base layer made of a polyester resin and an adhesive layer laminated on one surface or both surfaces of the base layer and obtained by coating and drying a water based coating composition containing a modified polyolefin based resin containing a carboxyl group at a content of 0.01 to 10 weight%, a wetting agent, a cross linking agent being a mixture of an oxazoline based cross linking agent and a melamine based cross linking agent, and water.

The back sheet for a solar cell module may further include a functional film selected from a fluoride film and a polyester film on one surface of the base layer on which the adhesive layer is not formed.

In another general aspect, there is provided a manufacturing method of a back sheet for a solar cell module, the manufacturing method including:

a) melt-extruding a polyester resin to manufacture a polyester sheet;
b) stretching the polyester sheet in a machine direction;
c) coating a water based coating composition containing a modified polyolefin based resin containing 0.01 to 10 weight% of carboxyl group, a wetting agent, a cross linking agent being a mixture of an oxazoline based cross linking agent and a melamine based cross linking agent, and water onto one surface or both surfaces of the stretched polyester film and then stretching the coated film in a transverse direction; and
d) heat-setting the bi-axially stretched polyester film.

The manufacturing method may further include, after step d), e) laminating a functional film selected from a fluoride film, a polyester based film, and a polyolefin based film on one surface of a base layer on which an adhesive film of the polyester film is not formed.

[EFFECT OF THE INVENTION]

In a back sheet for a solar cell module according to the present invention, a manufacturing process may be simplified, a manufacturing cost may be decreased by removing one fluoride film layer, and adhesive force between the sealing EVA and the back sheet may be equal to or more than that between the existing fluoride film and EVA.

[EMBODIMENTS FOR CARRYING OUT THE INVENTION]

Hereinafter, the present invention will be described in more detail.

An object of the present invention is to provide a back sheet having excellent hydrolysis resistance and adhesion in a structure in which a Tedlar film/PET film/Tedlar film are laminated without using a Tedlar film adhered to a sealing material. The present invention is characterized by forming an excellent adhesive layer on a polyester film in an in-line coating method so as to have excellent adhesion between the polyester film and EVA, which is a sealing material, while decreasing a manufacturing process.

In the case in which the adhesive layer is applied onto the PET film by an off-line coating method, a process is additionally increased, and a coating thickness is increased, such that a cost may also be increased, and adhesion with the polyester film may be decreased. Therefore, the present inventors discovered that when a water dispersion coating composition (emulsion) is applied during a stretching process of a manufacturing process of the PET film by the in-line coating method, the coating thickness may be thin, adhesion with the PET film may become excellent, and adhesion with the EVA resin, which is a sealing material of a solar cell module, thereby completing the present invention.

In addition, in a composition for forming an ethylene vinyl acetate adhesive layer, since the EVA film, which is the sealing film, and the back sheet is heat-adhered to each other during a process of assembling the solar cell module, a modified polyolefin based resin containing a carboxyl group at a content of 0.01 to 10 weight% is used as a matrix resin forming a water dispersion composition (emulsion) so as to exhibit sufficient adhesive force at the time of heat-adhesion at a high temperature, and a cross linking agent being a mixture of an oxazoline based cross linking agent and a melamine based cross linking agent for improving hydrolysis resistance and durability of the resin.

Further, in order to be used in an in-line process, the composition needs to be prepared as the water dispersion composition (emulsion). The present invention is characterized in that the composition having excellent water dispersion property is prepared by adding a specific wetting agent and a dispersion stabilizer to the modified polyolefin based resin containing the carboxyl group at a content of 0.01 to 10 weight%.

In one general aspect of the present invention, there is provided a back sheet for a solar cell module including a base layer made of a polyester resin and an adhesive layer laminated on one surface or both surfaces of the base layer and obtained by coating and drying a water based coating composition containing a modified polyolefin based resin containing a carboxyl group at a content of 0.01 to 10 weight%, a wetting agent, a cross linking agent being a mixture of an oxazoline based cross linking agent and a melamine based cross linking agent, and water.

In another general aspect of the present invention, there is provided a back sheet for a solar cell module including a base layer made of a polyester resin, an adhesive layer laminated on the base layer and obtained by coating and drying a coating composition containing a modified polyolefin based resin containing a carboxyl group at a content of 0.01 to 10 weight%, a cross linking agent, and water, and a functional film selected from a fluoride film, a polyester based film, and a polyolefin film and laminated on a surface opposite to a surface of the base layer on which the adhesive layer is formed.

In the present invention, the adhesive layer may be a surface adhered so as to correspond to the EVA, which is a sealing material.

Hereinafter, the present invention will be described in more detail.

In the present invention, as the polyester film, a polyethylene terephthalate film or a polyethylene naphthalate film may be used. A polyethylene terephthalate film having an intrinsic viscosity of 0.6 to 0.7 may be more preferably used due to excellent water resistance and hydrolysis resistance thereof. In addition, the polyester film having a thickness of 12 to 300 $\mu$m may be preferable since it is advantageous in view of production and implementation of various lamination structures.

According to the present invention, during the manufacturing the polyester film as described above, the adhesive layer is formed by the in-line coating method.

The adhesive layer may have a dried coating thickness of 10 to 500nm and adhesive force of 39 to 118 N/cm$^2$ (4 to 12kg/cm$^2$), wherein the adhesive force is measured between an EVA film and the adhesive layer by peeling off each other at room temperature, a peeling angle of 180 degrees, and a peeling rate of 300mm/min. In the case in which the dried coating thickness is less than 10nm, the adhesive force may be weak, and in the case in which the thickness is more than 500nm, the cost and adhesion property may be increased, such that processability may be deteriorated. Further, in the case in which the adhesive force is in a range of 39 to 118 N/cm$^2$ (4 to 12kg/cm$^2$), the adhesive force equal to or more than that of the Tedlar film according to the related art may be obtained.

The water dispersion composition (emulsion) for forming the adhesive layer may contain 0.1 to 20 weight% of the modified polyolefin based resin containing 0.01 to 10 weight% of the carboxyl group, 0.01 to 20 weight% of the cross linking agent, 0.01 to 0.5 weight% of the wetting agent, and the rest water.

When the content of the carboxyl group is 0.01 to 10 weight%, the adhesive force may be excellent, and when the content is preferably 1 to 8 weight%, more preferably 3 to 4 weight%, the most excellent adhesive force may be obtained.

The case in which the modified polyolefin based resin is a modified polyethylene resin is most preferable since properties with the EVA, which is a sealing material, may be excellent. More specifically, a modified polyethylene resin having a viscosity average molecular weight of 30,000 to 50,000 and adhesive force of 39 to 118 N/cm$^2$ (4 to 12kgf/cm$^2$) may be preferably used. More specifically, as a commercialized example, SE-100 series, SE-1200 series (Unitika Corp., Japan), may be used.

A content of the modified polyolefin based resin may be preferably 0.1 to 20 weight% based on the total emulsion coating composition. In the case in which the content is less than 0.1 weight%, the adhesive force may be low, and in the case in which the content is more than 20 weight%, the cost and the adhesion property may be increased, such that the processability may be deteriorated. Therefore, when the content of the modified polyolefin based resin is in the above-mentioned range, the adhesive layer having the most excellent adhesion force may be formed.

As the cross linking agent, a mixture of an oxazoline based cross linking agent and a melamine based cross linking agent is used, and the content of the cross linking agent in the total composition may be preferably 0.01 to 20 weight%.

The oxazoline based cross linking agent may be used to improve initial adhesive force, and the melamine based cross linking agent may be used to improve final adhesive force.

As the additive, an emulsifier, an inorganic particle or alcohol may be used, and a content of the additive may be preferably 0.01 to 40 weight%.

The emulsifier is used to water-disperse the modified polyolefin based resin, and a non-ionic, anionic, and cationic surfactant may be used. A content of the emulsifier may be 0.01 to 1 weight%.

The wetting agent present in the water based coating composition is used to allow the emulsion to be uniformly coated onto the polyester film, and one selected from polyethylene glycol, polyethylene ester, modified silicon may be preferably used since a coating property may be improved. As a specific example, there are F0-28 (NNOP Corp., Japan), Q2-5212 (Dow Corning Corp.). It is preferable that a content of the wetting agent is 0.01 to 0.5 weight% since adhesive force is excellent.

Further, as needed, particles may be added in order to improve a slip property of a coating layer using ethylene vinyl acetate emulsion. Inorganic particles or organic particles may be added. A content of the particle may be preferably 0.01 to 5 weight%.

The alcohol is used to increase a wetting property to uniformly apply the composition, and as a specific example, there is isopropyl alcohol. A content thereof may be preferably 1 to 20 weight%.

In addition, as needed, other additives generally used in the art such as an UV stabilizer and anti-static agent may be added.

In the present invention, as the fluoride film, a film made of poly vinyl fluoride (PVF) or poly vinyllidene difluoride (PVDF) may be used, and as commercialized examples, there are Tedlar and Kynar. The fluoride film may be laminated on the surface opposite to the surface of the polyester film on which the adhesive layer is formed by the in-line coating method, using an adhesive such as a polyurethane based adhesive or a polyester based adhesive.

Next, a manufacturing method of a back sheet according to the present invention will be described in detail.

The manufacturing method of a back sheet according to the present invention may include: melt-extruding a polyester resin to manufacture a sheet, uni-axially stretching the sheet, coating a coating composition emulsion, and bi-axially stretching in a transverse direction to manufacture a polyester film, and may further include laminating a fluoride film on the polyester film using an adhesive.

More specifically, the manufacturing method of a polyester film included in the back sheet for a solar cell module according to the present invention includes:

a) melt-extruding the polyester resin to manufacture a polyester sheet;
b) stretching the polyester sheet in a machine direction;
c) coating a water based coating composition containing a modified polyolefin based resin containing 0.01 to 10 weight% of carboxyl group, a wetting agent, a cross linking agent being a mixture of an oxazoline based cross linking agent and a melamine based cross linking agent, and water onto one surface or both surfaces of the stretched polyester film in the machine direction and then stretching the coated film in the transverse direction; and
d) heat-setting the bi-axially stretched polyester film.

Step a) is a process of melt-extruding the resin from a cylinder to manufacture the sheet through a T-die in order to manufacture the polyester film.

Step b) is a process of bi-axially stretching the polyester sheet in order to manufacture the polyester film, and the stretching in the machine direction may be preferably performed using at least one roller.

Next, in step c), an adhesive layer is formed by an in-line coating method. In this case, water dispersion emulsion may be preferably used so as to be used in the in-line coating. In this case, a configuration of the coating composition for forming the adhesive layer may be the same as described above, and preferably, the coating composition may be applied so that a dried coating thickness after stretching becomes 10 to 500nm at the time of the application. After the adhesive layer is formed by coating the coating composition, the coated film may be stretched in the transverse direction. In this case, the stretching in the transverse direction may be performed using a tenter.

Then, water used in the hot-melt adhesive layer is removed, the adhesive layer is cured, and a drying and heat-fixing process is performed in order to prevent the film from being shrunk.

In addition, as needed, before coating the coating composition or coating the adhesive for adhering a functional film, corona treatment may be performed on the surface of the polyester film, which is a base layer.

As the functional film, a fluoride film, a polyester based film or a polyolefin based film may be used.

Hereinafter, Examples will be provided in order to describe the present invention in more detail. However, the present invention is not limited to the following Examples.

Physical properties in the present invention were measured as follows.

1) Adhesive force

Adhesive force between an EVA film, which is a sealing film, and an adhesive layer according to the present invention was evaluated. The sealing EVA film and the adhesive layer were laminated so as to contact each other and adhered to each other at 150 °C for 20 minutes at a condition of 70g/cm$^2$, then they were peeled off each other at room temperature, a peeling angle of 180 degrees, and a peeling rate of 300mm/min, thereby evaluating the adhesive force.

2) Hydrolysis resistance

After the sealing EVA film and the adhesive layer were laminated so as to contact each other and adhered to each other at 150°C for 20 minutes at a condition of 70g/cm$^2$, the obtained film was hung on a sample hanger in an autoclave to be put into the autoclave while allowing the film not to be immersed in water, then the sample was aged at a high temperature (121), high humidity (100% RH), and pressure of 2 bar for 30 hours.

Then, peeling was performed by the same method as in the adhesive force test, thereby evaluating an adhesive force maintenance ratio based on the initial adhesive force.

$$\text{Adhesive force maintenance ratio (\%)} = (\text{adhesive force after aging/initial adhesive force}) \times 100$$

[Reference Example 1]

Preparation of coating composition 1

2 weight% of SE-1015J2 (Unitika Corp., Japan) containing 90 weight% of modified polyolefin based resin containing 4 weight% of carboxyl group and 10 weight% of oxazoline based cross linking agent (1.8 weight% of modified polyolefin based resin and 0.2 weight% of oxazoline based cross linking agent were contained in the entire coating composition), 0.3 weight% of wetting agent (Q2-5210, Dow Corning Corp.), and 97.7 weight% of water were mixed, thereby preparing a coating composition 1.

Manufacturing a polyester film for a back sheet

After a polyethylene terephthalate chip from which moisture was removed at a content of 100ppm or less was injected into a melt-extruder and melted, the resultant was cooled and solidified by a casting drum having a surface temperature of 20 °C while being extruded through a T-die, thereby manufacturing a polyethylene terephthalate sheet having a thickness of 2000$\mu$m.

The manufactured polyethylene terephthalate sheet was stretched 3.5 times in the machine direction (MD) at 110 °C and cooled to room temperature. Next, after the coating composition 1 was coated on one side of the sheet by a bar coating method, the stretched sheet was stretched 3.5 times in a transverse direction (TD) by preheating and drying at 140°C. Then, after heat-treatment was performed in a 5-stage tenter at 235°C, the heat-treated film was relaxed by 10% in the machine and transverse directions to be heat-set at 200°C, thereby manufacturing a bi-axially stretched film including an adhesive layer formed on one side thereof and having a thickness of 250 $\mu$m. The adhesive layer had a dried coating thickness of 50nm after stretching.

A single layer of the manufactured film was used as a back sheet for a solar cell module. The physical properties of the back sheet obtained as described above were shown in the following Table 1.

[Reference Example 2]

Preparation of coating composition 2

4 weight% of SE-1015J2 (Unitika Corp., Japan) containing 90 weight% of modified polyolefin based resin containing 4 weight% of carboxyl group and 10 weight% of oxazoline based cross linking agent (3.6 weight% of modified polyolefin based resin and 0.4 weight% of oxazoline based cross linking agent were contained in the entire coating composition), 0.3 weight% of wetting agent (Q2-5210, Dow Corning Corp.), and 95.7 weight% of water were mixed, thereby preparing a coating composition 2.

Manufacturing a polyester film for a back sheet

After a polyethylene terephthalate chip from which moisture was removed at a content of 100ppm or less was injected into a melt-extruder and melted, the resultant was cooled and solidified by a casting drum having a surface temperature of 20 °C while being extruded through a T-die, thereby manufacturing a polyethylene terephthalate sheet having a thickness of 2000$\mu$m.

The manufactured polyethylene terephthalate sheet was stretched 3.5 times in the machine direction (MD) at 110 °C and cooled to room temperature. Next, after the coating composition 2 was coated on one side of the sheet by a bar coating method, the stretched sheet was stretched 3.5 times in a transverse direction (TD) by preheating and drying at 140°C. Then, after thermal treatment was performed in a 5-stage tenter at 235°C, the thermally treated film was relaxed by 10% in the machine and transverse directions to be heat-set at 200°C, thereby manufacturing a bi-axially stretched film including an adhesive layer formed on one side thereof and having a thickness of 250 $\mu$m. The adhesive layer had a dried coating thickness of 100nm after stretching.

A single layer of the manufactured film was used as a back sheet for a solar cell module. The physical properties of the back sheet obtained as described above were shown in the following Table 1.

[Reference Example 3]

Preparation of coating composition 3

6 weight% of SE-1015J2 (Unitika Corp., Japan) containing 90 weight% of modified polyolefin based resin containing 4 weight% of carboxyl group and 10 weight% of oxazoline based cross linking agent (5.4 weight% of modified polyolefin based resin and 0.6 weight% of oxazoline based cross linking agent were contained in the entire coating composition), 0.3 weight% of wetting agent (Q2-5210, Dow Corning Corp.), and 93.7 weight% of water were mixed, thereby preparing a coating composition 3.

Manufacturing a polyester film for a back sheet

After a polyethylene terephthalate chip from which moisture was removed at a content of 100ppm or less was injected into a melt-extruder and melted, the resultant was cooled and solidified by a casting drum having a surface temperature of 20 °C while being extruded through a T-die, thereby manufacturing a polyethylene terephthalate sheet having a thickness of 2000$\mu$m.

The manufactured polyethylene terephthalate sheet was stretched 3.5 times in the machine direction (MD) at 110 °C and cooled to room temperature. Next, after the coating composition 3 was coated on one side of the sheet by a bar coating method, the stretched sheet was stretched 3.5 times in a transverse direction (TD) by preheating and drying at 140°C. Then, after thermal treatment was performed in a 5-stage tenter at 235°C, the thermally treated film was relaxed by 10% in the machine and transverse directions to be heat-set at 200°C, thereby manufacturing a bi-axially stretched film including an adhesive layer formed on one side thereof and having a thickness of 250 $\mu$m. The adhesive layer had a dried coating thickness of 150nm after stretching.

A single layer of the manufactured film was used as a back sheet for a solar cell module. The physical properties of the back sheet obtained as described above were shown in the following Table 1.

[Reference Example 4]

Preparation of coating composition 4

8 weight% of SE-1015J2 (Unitika Corp., Japan) containing 90 weight% of modified polyolefin based resin containing 4 weight% of carboxyl group and 10 weight% of oxazoline based cross linking agent (7.2 weight% of modified polyolefin based resin and 0.8 weight% of oxazoline based cross linking agent were contained in the entire coating composition), 0.3 weight% of wetting agent (Q2-5210, Dow Corning Corp.), and 91.7 weight% of water were mixed, thereby preparing a coating composition 4.

Manufacturing a polyester film for a back sheet

After a polyethylene terephthalate chip from which moisture was removed at a content of 100ppm or less was injected into a melt-extruder and melted, the resultant was cooled and solidified by a casting drum having a surface temperature of 20 °C while being extruded through a T-die, thereby manufacturing a polyethylene terephthalate sheet having a thickness of 2000$\mu$m.

The manufactured polyethylene terephthalate sheet was stretched 3.5 times in the machine direction (MD) at 110 °C and cooled to room temperature. Next, after the coating composition 4 was coated on one side of the sheet by a bar coating method, the stretched sheet was stretched 3.5 times in a transverse direction (TD) by preheating and drying at 140°C. Then, after thermal treatment was performed in a 5-stage tenter at 235°C, the thermally treated film was relaxed by 10% in the machine and transverse directions to be heat-set at 200°C, thereby manufacturing a bi-axially stretched film including an adhesive layer formed on one side thereof and having a thickness of 250 $\mu$m. The adhesive layer had a dried coating thickness of 200nm after stretching.

A single layer of the manufactured film was used as a back sheet for a solar cell module. The physical properties of the back sheet obtained as described above were shown in the following Table 1.

[Reference Example 5]

Preparation of coating composition 5

12 weight% of SE-1015J2 (Unitika Corp., Japan) containing 90 weight% of modified polyolefin based resin containing 4 weight% of carboxyl group and 10 weight% of oxazoline based cross linking agent (10.8 weight% of modified polyolefin based resin and 1.2 weight% of oxazoline based cross linking agent were contained in the entire coating composition), 0.3 weight% of wetting agent (Q2-5210, Dow Corning Corp.), and 87.7 weight% of water were mixed, thereby preparing a coating composition 5.

Manufacturing a polyester film for a back sheet

After a polyethylene terephthalate chip from which moisture was removed at a content of 100ppm or less was injected into a melt-extruder and melted, the resultant was cooled and solidified by a casting drum having a surface temperature of 20 °C while being extruded through a T-die, thereby manufacturing a polyethylene terephthalate sheet having a thickness of 2000$\mu$m.

The manufactured polyethylene terephthalate sheet was stretched 3.5 times in the machine direction (MD) at 110 °C and cooled to room temperature. Next, after the coating composition 5 was coated on one side of the sheet by a bar coating method, the stretched sheet was stretched 3.5 times in a transverse direction (TD) by preheating and drying at 140°C. Then, after thermal treatment was performed in a 5-stage tenter at 235°C, the thermally treated film was relaxed by 10% in the machine and transverse directions to be heat-set at 200°C, thereby manufacturing a bi-axially stretched film including an adhesive layer formed on one side thereof and having a thickness of 250 $\mu$m. The adhesive layer had a dried coating thickness of 300nm after stretching.

A single layer of the manufactured film was used as a back sheet for a solar cell module. The physical properties of the back sheet obtained as described above were shown in the following Table 1.

[Reference Example 6]

Preparation of coating composition 6

4 weight% of SE-1015J2 (Unitika Corp., Japan) containing 90 weight% of modified polyolefin based resin containing 4 weight% of carboxyl group and 10 weight% of oxazoline based cross linking agent (3.6 weight% of modified polyolefin based resin and 0.4 weight% of oxazoline based cross linking agent were contained in the entire coating composition), 0.3 weight% of wetting agent (Q2-5210, Dow Corning Corp.), 10 weight% of isopropyl alcohol, and 85.7 weight% of water were mixed, thereby preparing a coating composition 6.

Manufacturing a polyester film for a back sheet

After a polyethylene terephthalate chip from which moisture was removed at a content of 100ppm or less was injected into a melt-extruder and melted, the resultant was cooled and solidified by a casting drum having a surface temperature of 20 °C while being extruded through a T-die, thereby manufacturing a polyethylene terephthalate sheet having a thickness of 2000$\mu$m.

The manufactured polyethylene terephthalate sheet was stretched 3.5 times in the machine direction (MD) at 110 °C and cooled to room temperature. Next, after the coating composition 6 was coated on one side of the sheet by a bar coating method, the stretched sheet was stretched 3.5 times in a transverse direction (TD) by preheating and drying at 140°C. Then, after thermal treatment was performed in a 5-stage tenter at 235°C, the thermally treated film was relaxed by 10% in the machine and transverse directions to be heat-set at 200°C, thereby manufacturing a bi-axially stretched film including an adhesive layer formed on one side thereof and having a thickness of 250 $\mu$m. The adhesive layer had a dried coating thickness of 100nm after stretching.

A single layer of the manufactured film was used as a back sheet for a solar cell module. The physical properties of the back sheet obtained as described above were shown in the following Table 1.

[Example 7]

Preparation of coating composition 7

2 weight% of SE-1201JS (Unitika Corp., Japan) containing 90 weight% of modified polyolefin based resin containing 3 weight% of carboxyl group, 5 weight% of oxazoline based cross linking agent, and 5 weight% of melamine based cross linking agent (1.8 weight% of modified polyolefin based resin, 0.1 weight% of oxazoline based cross linking agent, and 0.1 weight% of melamine based cross linking agent were contained in the entire coating composition), 0.3 weight% of wetting agent (Q2-5210, Dow Corning Corp.), and 97.7 weight% of water were mixed, thereby preparing a coating composition 7.

Manufacturing a polyester film for a back sheet

After a polyethylene terephthalate chip from which moisture was removed at a content of 100ppm or less was injected into a melt-extruder and melted, the resultant was cooled and solidified by a casting drum having a surface temperature of 20 °C while being extruded through a T-die, thereby manufacturing a polyethylene terephthalate sheet having a thickness of 2000$\mu$m.

The manufactured polyethylene terephthalate sheet was stretched 3.5 times in the machine direction (MD) at 110 °C and cooled to room temperature. Next, after the coating composition 7 was coated on one side of the sheet by a bar coating method, the stretched sheet was stretched 3.5 times in a transverse direction (TD) by preheating and drying at 140°C. Then, after thermal treatment was performed in a 5-stage tenter at 235°C, the thermally treated film was relaxed by 10% in the machine and transverse directions to be heat-set at 200°C, thereby manufacturing a bi-axially stretched film including an adhesive layer formed on one side thereof and having a thickness of 250 $\mu$m. The adhesive layer had a dried coating thickness of 50nm after stretching.

A single layer of the manufactured film was used as a back sheet for a solar cell module. The physical properties of the back sheet obtained as described above were shown in the following Table 1.

[Example 8]

Preparation of coating composition 8

4 weight% of SE-1201JS (Unitika Corp., Japan) containing 90 weight% of modified polyolefin based resin containing 3 weight% of carboxyl group, 5 weight% of oxazoline based cross linking agent, and 5 weight% of melamine based cross linking agent (3.6 weight% of modified polyolefin based resin, 0.2 weight% of oxazoline based cross linking agent, and 0.2 weight% of melamine based cross linking agent were contained in the entire coating composition), 0.3 weight% of wetting agent (Q2-5210, Dow Corning Corp.), and 95.7 weight% of water were mixed, thereby preparing a coating composition 8.

Manufacturing a polyester film for a back sheet

After a polyethylene terephthalate chip from which moisture was removed at a content of 100ppm or less was injected into a melt-extruder and melted, the resultant was cooled and solidified by a casting drum having a surface temperature of 20 °C while being extruded through a T-die, thereby manufacturing a polyethylene terephthalate sheet having a thickness of 2000$\mu$m.

The manufactured polyethylene terephthalate sheet was stretched 3.5 times in the machine direction (MD) at 110 °C and cooled to room temperature. Next, after the coating composition 8 was coated on one side of the sheet by a bar coating method, the stretched sheet was stretched 3.5 times in a transverse direction (TD) by preheating and drying at 140°C. Then, after thermal treatment was performed in a 5-stage tenter at 235°C, the thermally treated film was relaxed by 10% in the machine and transverse directions to be heat-set at 200°C, thereby manufacturing a bi-axially stretched film including an adhesive layer formed on one side thereof and having a thickness of 250 $\mu$m. The adhesive layer had a dried coating thickness of 100nm after stretching.

A single layer of the manufactured film was used as a back sheet for a solar cell module. The physical properties of the back sheet obtained as described above were shown in the following Table 1.

[Example 9]

Preparation of coating composition 9

6 weight% of SE-1201JS (Unitika Corp., Japan) containing 90 weight% of modified polyolefin based resin containing 3 weight% of carboxyl group, 5 weight% of oxazoline based cross linking agent, and 5 weight% of melamine based cross linking agent (5.4 weight% of modified polyolefin based resin, 0.3 weight% of oxazoline based cross linking agent, and 0.3 weight% of melamine based cross linking agent were contained in the entire coating composition), 0.3 weight% of wetting agent (Q2-5210, Dow Corning Corp.), and 93.7 weight% of water were mixed, thereby preparing a coating composition 9.

Manufacturing a polyester film for a back sheet

After a polyethylene terephthalate chip from which moisture was removed at a content of 100ppm or less was injected into a melt-extruder and melted, the resultant was cooled and solidified by a casting drum having a surface temperature of 20 °C while being extruded through a T-die, thereby manufacturing a polyethylene terephthalate sheet having a thickness of 2000$\mu$m.

The manufactured polyethylene terephthalate sheet was stretched 3.5 times in the machine direction (MD) at 110 °C and cooled to room temperature. Next, after the coating composition 9 was coated on one side of the sheet by a bar coating method, the stretched sheet was stretched 3.5 times in a transverse direction (TD) by preheating and drying at 140°C. Then, after thermal treatment was performed in a 5-stage tenter at 235°C, the thermally treated film was relaxed by 10% in the machine and transverse directions to be heat-set at 200°C, thereby manufacturing a bi-axially stretched film including an adhesive layer formed on one side thereof and having a thickness of 250 $\mu$m. The adhesive layer had a dried coating thickness of 150nm after stretching.

A single layer of the manufactured film was used as a back sheet for a solar cell module. The physical properties of the back sheet obtained as described above were shown in the following Table 1.

[Example 10]

Preparation of coating composition 10

8 weight% of SE-1201JS (Unitika Corp., Japan) containing 90 weight% of modified polyolefin based resin containing 3 weight% of carboxyl group, 5 weight% of oxazoline based cross linking agent, and 5 weight% of melamine based cross linking agent (7.2 weight% of modified polyolefin based resin, 0.4 weight% of oxazoline based cross linking agent, and 0.4 weight% of melamine based cross linking agent were contained in the entire coating composition), 0.3 weight% of wetting agent (Q2-5210, Dow Corning Corp.), and 91.7 weight% of water were mixed, thereby preparing a coating composition 10.

Manufacturing a polyester film for a back sheet

After a polyethylene terephthalate chip from which moisture was removed at a content of 100ppm or less was injected into a melt-extruder and melted, the resultant was cooled and solidified by a casting drum having a surface temperature of 20 °C while being extruded through a T-die, thereby manufacturing a polyethylene terephthalate sheet having a thickness of 2000$\mu$m.

The manufactured polyethylene terephthalate sheet was stretched 3.5 times in the machine direction (MD) at 110 °C and cooled to room temperature. Next, after the coating composition 10 was coated on one side of the sheet by a bar coating method, the stretched sheet was stretched 3.5 times in a transverse direction (TD) by preheating and drying at 140°C. Then, after thermal treatment was performed in a 5-stage tenter at 235°C, the thermally treated film was relaxed by 10% in the machine and transverse directions to be heat-set at 200°C, thereby manufacturing a bi-axially stretched film including an adhesive layer formed on one side thereof and having a thickness of 250 $\mu$m. The adhesive layer had a dried coating thickness of 200nm after stretching.

A single layer of the manufactured film was used as a back sheet for a solar cell module. The physical properties of the back sheet obtained as described above were shown in the following Table 1.

[Example 11]

Preparation of coating composition 11

12 weight% of SE-1201JS (Unitika Corp., Japan) containing 90 weight% of modified polyolefin based resin containing 3 weight% of carboxyl group, 5 weight% of oxazoline based cross linking agent, and 5 weight% of melamine based cross linking agent (10.8 weight% of modified polyolefin based resin, 0.6 weight% of oxazoline based cross linking agent, and 0.6 weight% of melamine based cross linking agent were contained in the entire coating composition), 0.3 weight% of wetting agent (Q2-5210, Dow Corning Corp.), and 87.7 weight% of water were mixed, thereby preparing a coating composition 11.

Manufacturing a polyester film for a back sheet

After a polyethylene terephthalate chip from which moisture was removed at a content of 100ppm or less was injected into a melt-extruder and melted, the resultant was cooled and solidified by a casting drum having a surface temperature of 20 °C while being extruded through a T-die, thereby manufacturing a polyethylene terephthalate sheet having a thickness of 2000$\mu$m.

The manufactured polyethylene terephthalate sheet was stretched 3.5 times in the machine direction (MD) at 110 °C and cooled to room temperature. Next, after the coating composition 11 was coated on one side of the sheet by a bar coating method, the stretched sheet was stretched 3.5 times in a transverse direction (TD) by preheating and drying at 140°C. Then, after thermal treatment was performed in a 5-stage tenter at 235°C, the thermally treated film was relaxed by 10% in the machine and transverse directions to be heat-set at 200°C, thereby manufacturing a bi-axially stretched film including an adhesive layer formed on one side thereof and having a thickness of 250 $\mu$m. The adhesive layer had a dried coating thickness of 300nm after stretching.

A single layer of the manufactured film was used as a back sheet for a solar cell module. The physical properties of the back sheet obtained as described above were shown in the following Table 1.

[Example 12]

Preparation of coating composition 12

4 weight% of SE-1201JS (Unitika Corp., Japan) containing 90 weight% of modified polyolefin based resin containing 3 weight% of carboxyl group, 5 weight% of oxazoline based cross linking agent, and 5 weight% of melamine based cross linking agent (3.6 weight% of modified polyolefin based resin, 0.2 weight% of oxazoline based cross linking agent, and 0.2 weight% of melamine based cross linking agent were contained in the entire coating composition), 0.3 weight% of wetting agent (Q2-5210, Dow Corning Corp.), 10 weight% of isopropyl alcohol, and 85.7 weight% of water were mixed, thereby preparing a coating composition 12.

Manufacturing a polyester film for a back sheet

After a polyethylene terephthalate chip from which moisture was removed at a content of 100ppm or less was injected into a melt-extruder and melted, the resultant was cooled and solidified by a casting drum having a surface temperature of 20 °C while being extruded through a T-die, thereby manufacturing a polyethylene terephthalate sheet having a thickness of 2000$\mu$m.

The manufactured polyethylene terephthalate sheet was stretched 3.5 times in the machine direction (MD) at 110 °C and cooled to room temperature. Next, after the coating composition 12 was coated on one side of the sheet by a bar coating method, the stretched sheet was stretched 3.5 times in a transverse direction (TD) by preheating and drying at 140°C. Then, after thermal treatment was performed in a 5-stage tenter at 235°C, the thermally treated film was relaxed by 10% in the machine and transverse directions to be heat-set at 200°C, thereby manufacturing a bi-axially stretched film including an adhesive layer formed on one side thereof and having a thickness of 250 $\mu$m. The adhesive layer had a dried coating thickness of 100nm after stretching.

A single layer of the manufactured film was used as a back sheet for a solar cell module. The physical properties of the back sheet obtained as described above were shown in the following Table 1.

[Comparative example 1]

Preparation of coating composition 13

8 weight% of SE-1010 ((Unitika Corp., Japan) made of 100 weigh% of modified polyolefin based resin containing 4 weight% of carboxyl group, 0.3 weight% of wetting agent (Q2-5210, Dow Corning Corp.), and 91.7 weight% of water were mixed, thereby preparing a coating composition 13. In this case, a cross linking agent was not used.

Manufacturing a polyester film for a back sheet

After a polyethylene terephthalate chip from which moisture was removed at a content of 100ppm or less was injected into a melt-extruder and melted, the resultant was cooled and solidified by a casting drum having a surface temperature of 20 °C while being extruded through a T-die, thereby manufacturing a polyethylene terephthalate sheet having a thickness of 2000$\mu$m.

The manufactured polyethylene terephthalate sheet was stretched 3.5 times in the machine direction (MD) at 110 °C and cooled to room temperature. Next, after the coating composition 13 was coated on one side of the sheet by a bar coating method, the stretched sheet was stretched 3.5 times in a transverse direction (TD) by preheating and drying at 140°C. Then, after thermal treatment was performed in a 5-stage tenter at 235°C, the thermally treated film was relaxed by 10% in the machine and transverse directions to be heat-set at 200°C, thereby manufacturing a bi-axially stretched film including an adhesive layer formed on one side thereof and having a thickness of 250 $\mu$m. The adhesive layer had a dried coating thickness of 200nm after stretching.

A single layer of the manufactured film was used as a back sheet for a solar cell module. The physical properties of the back sheet obtained as described above were shown in the following Table 1.

[Comparative example 2]

Preparation of coating composition 14

8 weight% of NPA-400 ((Nanux Corp., Korea) made of 90 weigh% of modified polyolefin based resin containing 20 weight% of carboxyl group and 10 weight% of cross linking agent, 0.3 weight% of wetting agent (Q2-5210, Dow Corning Corp.), and 91.7 weight% of water were mixed, thereby preparing a coating composition 14.

Manufacturing a polyester film for a back sheet

After a polyethylene terephthalate chip from which moisture was removed at a content of 100ppm or less was injected into a melt-extruder and melted, the resultant was cooled and solidified by a casting drum having a surface temperature of 20 °C while being extruded through a T-die, thereby manufacturing a polyethylene terephthalate sheet having a thickness of 2000$\mu$m.

The manufactured polyethylene terephthalate sheet was stretched 3.5 times in the machine direction (MD) at 110 °C and cooled to room temperature. Next, after the coating composition 14 was coated on one side of the sheet by a bar coating method, the stretched sheet was stretched 3.5 times in a transverse direction (TD) by preheating and drying at 140°C. Then, after thermal treatment was performed in a 5-stage tenter at 235°C, the thermally treated film was relaxed by 10% in the machine and transverse directions to be heat-set at 200°C, thereby manufacturing a bi-axially stretched film including an adhesive layer formed on one side thereof and having a thickness of 250 $\mu$m. The adhesive layer had a dried coating thickness of 200nm after stretching.

A single layer of the manufactured film was used as a back sheet for a solar cell module. The physical properties of the back sheet obtained as described above were shown in the following Table 1.

[Table 1]

|  | Adhesive force (kg/cm$^2$) | Hydrolysis resistance |
|---|---|---|
| Reference Example 1 | 6.1 | 0.2 |
| Reference Example 2 | 6.9 | 0.4 |
| Reference Example 3 | 8.2 | 0.5 |
| Reference Example 4 | 6.6 | 0.5 |
| Reference Example 5 | 6.5 | 0.5 |

(continued)

|  | Adhesive force (kg/cm$^2$) | Hydrolysis resistance |
|---|---|---|
| Reference Example 6 | 6.9 | 0.4 |
| Example 7 | 6.1 | 1.4 |
| Example 8 | 6.6 | 1.3 |
| Example 9 | 6.4 | 1.3 |
| Example 10 | 6.2 | 1.4 |
| Example 11 | 6.2 | 1.3 |
| Example 12 | 6.6 | 1.3 |
| Comparative Example 1 | 1.3 | 0.0 |
| Comparative Example 2 | Less than 1.0 | 0.0 |

As shown in Table 1, it may be appreciated that the back sheets of Examples in which the adhesive layer according to the present invention was included had adhesive force in a range similar to that of the existing fluoride film and excellent hydrolysis resistance.

However, it may be appreciated that in Comparative Example 1 in which the cross linking agent was not included, the back sheet had low adhesive force and did not have hydrolysis resistance, and in Comparative Example 2 in which the carboxyl group was included at a high content of 20 weight%, the back sheet also had low adhesive force and did not have hydrolysis resistance.

**Claims**

1. A back sheet for a solar cell module comprising:

   a base layer made of a polyester resin; and
   an adhesive layer laminated on one surface or both surfaces of the base layer and obtained by coating and drying a water based coating composition containing a modified polyolefin based resin containing a carboxyl group at a content of 0.01 to 10 weight%, a wetting agent, a cross linking agent being a mixture of an oxazoline based cross linking agent and a melamine based cross linking agent, and water.

2. The back sheet for a solar cell module of claim 1, wherein the modified polyolefin resin is a modified polyethylene resin containing 1 to 8 weight% of carboxyl group.

3. The back sheet for a solar cell module of claim 2, wherein the modified polyethylene resin has adhesive force of 39 to 118 N/cm$^2$ (4 to 12kgf/cm$^2$),
   wherein the adhesive force is measured between an EVA film and the adhesive layer by peeling off each other at room temperature, a peeling angle of 180 degrees, and a peeling rate of 300mm/min.

4. The back sheet for a solar cell module of claim 1, wherein the coating composition contains 0.1 to 20 weight% of the modified polyolefin based resin containing 0.01 to 10 weight% of the carboxyl group, 0.01 to 20 weight% of the cross linking agent, 0.01-0.5 wt% of the wetting agent and the rest water.

5. The back sheet for a solar cell module of claim 4, wherein the coating composition further contains any one or at least two additives selected from an emulsifier, inorganic particles, and alcohol at a content of 0.01 to 40 weight%.

6. The back sheet for a solar cell module of claim 1, wherein the adhesive layer is formed by coating and drying the coating composition by an in-line coating method during a stretching process of a polyester film.

7. The back sheet for a solar cell module of claim 1, wherein the adhesive layer has a dried coating thickness of 10 to 500nm, adhesive force of 4 to 12kg/cm$^2$, and excellent heat adhesion.

**8.** The back sheet for a solar cell module of claim 1, further comprising a functional film selected from a fluoride film and a polyester film on one surface of the base layer on which the adhesive layer is not formed.

**9.** The back sheet for a solar cell module of claim 1, wherein the polyester film has a thickness of 12 to 300$\mu$m.

**10.** A manufacturing method of a back sheet for a solar cell module, the manufacturing method comprising:

  a) melt-extruding a polyester resin to manufacture a polyester sheet;
  b) stretching the polyester sheet in a machine direction;
  c) coating a water based coating composition containing a modified polyolefin based resin containing 0.01 to 10 weight% of carboxyl group, a wetting agent, a cross linking agent being a mixture of an oxazoline based cross linking agent and a melamine based cross linking agent, and water onto one surface or both surfaces of the stretched polyester film in the machine direction and then stretching the coated film in a transverse direction; and
  d) heat-setting the bi-axially stretched polyester film.

**11.** The manufacturing method of claim 10, wherein the coating composition is coated so that a dried coating thickness is 10 to 500nm after stretching.

**12.** The manufacturing method of claim 10, further comprising, after step d), e) laminating a functional film selected from a fluoride film, a polyester based film, and a polyolefin based film on one surface of a base layer on which an adhesive film of the polyester film is not formed.

**Patentansprüche**

**1.** Rückseitenfolie für ein Solarzellenmodul, umfassend:

  eine aus einem Polyesterharz hergestellte Grundschicht; und
  eine Klebstoffschicht, laminiert auf einer Seite oder beiden Seiten der Grundschicht, und erhalten durch Aufbeschichten und Trocknen einer wasserbasierten Beschichtungszusammensetzung, enthaltend ein modifiziertes Polyolefin-basiertes Harz, enthaltend eine Carboxylgruppe bei einem Gehalt von 0,01 bis 10 Gew.-%, ein Benetzungsmittel, ein Vernetzungsmittel, das eine Mischung aus einem Oxazolin-basierten Vernetzungsmittel und einem Melamin-basierten Vernetzungsmittel ist, und Wasser.

**2.** Rückseitenfolie für ein Solarzellenmodul nach Anspruch 1, wobei das modifizierte Polyolefinharz ein modifiziertes Polyethylenharz ist, enthaltend 1 bis 8 Gew.-% Carboxylgruppe.

**3.** Rückseitenfolie für ein Solarzellenmodul nach Anspruch 2, wobei das modifizierte Polyethylenharz eine Klebekraft von 39 bis 118 N/cm$^2$ (4 bis 12 kgf/cm$^2$) aufweist,
wobei die Klebekraft gemessen wird zwischen einer EVA-Folie und der Klebstoffschicht durch Abziehen voneinander bei Raumtemperatur, einem Abziehwinkel von 180 Grad und einer Abziehgeschwindigkeit von 300 mm/min.

**4.** Rückseitenfolie für ein Solarzellenmodul nach Anspruch 1, wobei die Beschichtungszusammensetzung 0,1 bis 20 Gew.-% des modifizerten Polyolefin-basierten Harzes, enthaltend 0,01 bis 10 Gew.-% der Carboxylgruppe, 0,01 bis 20 Gew.-% des Vernetzungsmittels, 0,01 bis 0,5 Gew.-% des Benetzungsmittels und den Rest Wasser enthält.

**5.** Rückseitenfolie für ein Solarzellenmodul nach Anspruch 4, wobei die Beschichtungszusammensetzung weiterhin irgendein oder mindestens zwei Additive enthält, gewählt aus einem Emulgiermittel, anorganischen Teilchen und Alkohol bei einem Gehalt von 0,01 bis 40 Gew.-%.

**6.** Rückseitenfolie für ein Solarzellenmodul nach Anspruch 1, wobei die Klebstoffschicht gebildet wird durch Aufbeschichten und Trocknen der Beschichtungszusammensetzung durch ein Inline-Beschichtungsverfahren während eines Streckprozesses einer Polyesterfolie.

**7.** Rückseitenfolie für ein Solarzellenmodul nach Anspruch 1, wobei die Klebstoffschicht eine Trockenbeschichtungsdicke von 10 bis 500 nm, eine Klebekraft von 4 bis 12 kg/cm$^2$ und eine ausgezeichnete Wärmeadhäsion aufweist.

**8.** Rückseitenfolie für ein Solarzellenmodul nach Anspruch 1, weiterhin umfassend einen funktionellen Film, gewählt aus einem Fluoridfilm und einem Polyesterfilm auf einer Seite der Grundschicht, auf welcher die Klebstoffschicht nicht gebildet ist.

**9.** Rückseitenfolie für ein Solarzellenmodul nach Anspruch 1, wobei die Polyesterfolie eine Dicke von 12 bis 300 $\mu$m aufweist.

**10.** Herstellungsverfahren für eine Rückseitenfolie für ein Solarzellenmodul, wobei das Herstellungsverfahren umfasst:

a) Schmelzextrudieren eines Polyesterharzes zur Herstellung einer Polyesterfolie;
b) Strecken der Polyesterfolie in einer Maschinenrichtung;
c) Aufbeschichten einer wasserbasierten Beschichtungszusammensetzung, enthaltend ein modifiziertes Polyolefin-basiertes Harz, enthaltend 0,01 bis 10 Gew.-% Carboxylgruppe, ein Benetzungsmittel, ein Vernetzungsmittel, das eine Mischung aus einem Oxazolin-basierten Vernetzungsmittel und einem Melamin-basierten Vernetzungsmittel ist, und Wasser, auf eine Oberfläche oder beide Oberflächen der gestreckten Polyesterfolie in der Maschinenrichtung und danach Strecken der beschichteten Folie in einer Querrichtung; und
d) Wärmefixieren der bi-axial gestreckten Polyesterfolie.

**11.** Herstellungsverfahren nach Anspruch 10, wobei die Beschichtungszusammensetzung so aufbeschichtet wird, dass eine Trockenbeschichtungsdicke nach dem Strecken 10 bis 500 nm beträgt.

**12.** Herstellungsverfahren nach Anspruch 10, weiterhin umfassend, nach Schritt d), e) Laminieren eines funktionellen Films, gewählt aus einem Fluoridfilm, einem Polyester-basierten Film und einem Polyolefin-basierten Film, auf eine Seite einer Grundschicht, auf welcher ein Klebstofffilm der Polyesterfolie nicht gebildet ist.

## Revendications

**1.** Une feuille arrière pour un module de cellule solaire comprenant:

une couche de base faite d'une résine de polyester; et
une couche adhésive stratifiée sur une surface ou les deux surfaces de la couche de base et obtenue par revêtement et séchage d'une composition de revêtement à base d'eau contenant une résine à base de polyoléfine modifiée contenant un groupe carboxyle à une teneur de 0,01 à 10% en poids , un agent mouillant, un agent de réticulation étant un mélange d'un agent de réticulation à base d'oxazoline et d'un agent de réticulation à base de mélamine, et de l'eau.

**2.** La feuille arrière pour un module de cellule solaire selon la revendication 1, dans laquelle la résine de polyoléfine modifiée est une résine de polyéthylène modifiée contenant 1 à 8% en poids de groupe carboxyle.

**3.** La feuille arrière pour un module de cellule solaire selon la revendication 2, dans laquelle la résine de polyéthylène modifiée a une force d'adhérence de 39 à 118 N/cm$^2$ (de 4 à 12 kgf / cm$^2$),
dans laquelle la force d'adhérence es mesurée entre un film EVA et une couche adhésive en décollant l'une de l'autre à température ambiante, à un angle de décollage de 180°, et à une vitesse de décollage de 300 mm/min.

**4.** La feuille arrière pour un module de cellule solaire selon la revendication 1, dans laquelle la composition de revêtement contient 0,1 à 20% en poids de la résine à base de polyoléfine modifiée contenant 0,01 à 10% en poids du groupe carboxyle, 0,01 à 20% en poids de l'agent de réticulation, 0,01 à 0,5% de l'agent de mouillant, et le reste de l'eau.

**5.** La feuille arrière pour un module de cellule solaire selon la revendication 4, dans laquelle la composition de revêtement contient en outre un ou au moins deux additifs choisis parmi un émulsifiant, des particules inorganiques et de l'alcool à une teneur de 0,01 à 40% en poids.

**6.** La feuille arrière pour un module de cellule solaire selon la revendication 1, dans laquelle la couche adhésive est formée par revêtement et séchage de la composition de revêtement par un procédé de revêtement en ligne pendant un processus d'étirage d'un film de polyester.

7. La feuille arrière pour un module de cellule solaire selon la revendication 1, dans laquelle la couche adhésive a une épaisseur de revêtement séché de 10 à 500 nm, une force d'adhérence de 4 à 12 kg / cm$^2$ et une excellente adhérence à la chaleur.

8. La feuille arrière pour un module de cellule solaire selon la revendication 1, comprenant en outre un film fonctionnel choisi parmi un film de fluorure et un film de polyester sur une surface de la couche de base sur laquelle la couche adhésive n'est pas formée.

9. La feuille arrière pour un module de cellule solaire selon la revendication 1, dans laquelle le film de polyester a une épaisseur de 12 à 300 $\mu$m.

10. Un procédé de fabrication d'une feuille arrière pour un module de cellule solaire, le procédé de fabrication comprenant:

   a) l'extrusion à l'état fondu d'une résine de polyester pour fabriquer une feuille de polyester;
   b) l'étirement de la feuille de polyester dans une direction de la machine;
   c) le revêtement d'une composition de revêtement à base d'eau contenant une résine à base de polyoléfine modifiée contenant 0,01 à 10% en poids de groupe carboxyle, un agent de réticulation étant un étant un mélange d'un agent de réticulation à base d'oxazoline et d'un agent de réticulation à base de mélamine, et de l'eau sur une surface ou les deux surfaces du film polyester étiré dans la direction de la machine et puis étirer le film revêtu dans une direction transversale; et
   d) thermofixer le film de polyester bi-axialement étiré.

11. Le procédé de fabrication selon la revendication 10, dans lequel la composition de revêtement est revêtue de telle sorte qu'une épaisseur de revêtement séché est de 10 à 500 nm après l'étirage.

12. Le procédé de fabrication selon la revendication 10, comprenant en outre, après l'étape d), e) la stratification d'un film fonctionnel choisi parmi un film de fluorure, un film à base de polyester, et un film à base de polyoléfine sur une surface d'une couche de base sur laquelle un film adhésif du film de polyester n'est pas formé.

**EP 2 819 177 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020110118953
- KR 1020110119134
- KR 1020110118271
- JP 2010251679 A
- WO 2011118844 A1